(19)

Europäisches
Patentamt
European
Patent Office
Office européen
des brevets

(11) **EP 2 093 582 A1**

(12) **EUROPEAN PATENT APPLICATION**

(43) Date of publication:
 **26.08.2009 Bulletin 2009/35**

(51) Int Cl.:
 ***G01R 31/36*** *(2006.01)*

(21) Application number: **08250628.8**

(22) Date of filing: **22.02.2008**

(84) Designated Contracting States:
 **AT BE BG CH CY CZ DE DK EE ES FI FR GB GR HR HU IE IS IT LI LT LU LV MC MT NL NO PL PT RO SE SI SK TR**
 Designated Extension States:
 **AL BA MK RS**

(71) Applicant: **TTPCOM Limited**
 **Royston,**
 **Hertfordshire, SG8 6HQ (GB)**

(72) Inventor: **George-Kelso, Simon**
 **Cambridge**
 **Cambridgeshire CB25 0JP (GB)**

(74) Representative: **Gillard, Matthew Paul et al**
 **Withers & Rogers LLP**
 **Goldings House**
 **2 Hays Lane**
 **London**
 **SE1 2HW (GB)**

(54) **Battery monitoring**

(57)    The used part of the capacity of a battery is evaluated by reference to data describing the behaviour of the terminal voltage of the battery during discharge. For example, measurements made on the battery can be mapped to a surface linking the drawn current, the terminal voltage and the proportion of capacity used, or departure from a steady current track can be used to refine a coarse estimate of a change in the proportion of capacity used.

Figure 10

EP 2 093 582 A1

Printed by Jouve, 75001 PARIS (FR)

**Description**

The invention relates to estimating the part of the capacity of a battery that has been expended in the supply of energy. Monitoring of this kind is commonplace in battery powered electrical products, such as mobile telephones. Indeed, the user display of a mobile telephone usually incorporates an indicator of the amount of battery life remaining. Often this indicator will provide coarse information and is typically in the form of a bar whose length can adopt one of four lengths to indicate remaining battery life. The coarseness of such indicators is symptomatic of current difficulties in accurately assessing remaining battery life.

According to one aspect, the invention provides a method of estimating a used part of the capacity of a battery, wherein, for a given steady current supplied by the battery, a corresponding discharge curve exists describing how the battery's terminal voltage varies as said used part increases and the method comprises: making a record of the behaviour of the terminal voltage in a discharge cycle of the battery; determining a value for the terminal voltage at an instant at which said used part is to be estimated; deducing from said record a value, for said instant, of the gradient of terminal voltage against said used part; and mapping said gradient value and said terminal voltage value onto a mathematical surface linking the parameters of terminal voltage, used part of capacity and steady current supplied from the battery.

The invention also consists in apparatus for estimating a used part of the capacity of a battery, wherein, for a given steady current supplied by the battery, a corresponding discharge curve exists describing how the battery's terminal voltage varies as said used part increases and the apparatus comprises: logging means for making a record of the behaviour of the terminal voltage in a discharge cycle of the battery; processing means for determining a value for the terminal voltage at an instant at which said used part is to be estimated; evaluating means for deducing from said record a value, for said instant, of the gradient of terminal voltage against said used part; and assessing means for mapping said gradient value and said terminal voltage value onto a mathematical surface linking the parameters of terminal voltage, used part of capacity and steady current supplied from the battery.

By locating a point on this mathematical surface, an estimate of the used part of the battery's capacity can be rendered.

In certain embodiments, the gradient value is determined from a value of rate of change of terminal voltage with time for said instant, which rate value is determined from said record. The rate value may be determined by taking the slope of a line fitted to average values of the terminal voltage for different sampling intervals. In other embodiments, the rate value may be determined by taking the slope of a line fitted to the maximum values of the terminal voltage for different sampling intervals.

In certain embodiments, the determined terminal voltage value is an average of samples of the terminal voltage taken during a sampling interval. In other embodiments, the determined terminal voltage value is the terminal voltage value at the moment at which the used part is to be estimated as found on a line fitted to average values of the terminal voltage for different sampling intervals.

In certain embodiments, a plurality of discharge curves describe the mathematical surface and the mapping is achieved by identifying a point on one of the discharge curves that is the best match for the gradient value and the determined terminal voltage value. In other embodiments, the mapping is achieved by interpolating from the discharge curves the point on the surface that is a match for the gradient and the determined terminal voltage value. In such embodiments, each of the discharge curves describes how the battery's terminal voltage varies as said used part increases for a corresponding steady current drawn from the battery.

According to a second aspect, the invention provides a method of estimating a used part of the capacity of a battery when the battery's terminal voltage has departed from a voltage versus time curve specific to the delivery of a certain steady current by the battery, wherein the method comprises: determining what the voltage is on said curve at an instant after the departure, at which instant said used part is to be estimated; estimating a coarse change in the used part occurring in an interval between said instant and a moment prior to, or at the time of, the departure, at which moment an earlier estimate of the used part was made; estimating an adjustment to said coarse change; and combining the earlier estimate, the coarse change and the adjustment to make an estimate of the used part at said instant; wherein: the coarse change is estimated as the fraction of the battery's energy capacity that would be exhausted if the battery delivered a terminal voltage of said determined voltage whilst supplying said steady current for the duration of the interval; and the adjustment is calculated as the fraction of the battery's Ampere-hour rating that would be exhausted by the supply over said interval of a current that would flow through the battery's internal impedance if a potential drop substantially equal to the difference between the terminal voltage at said instant and said determined voltage occurred across that impedance.

The invention also consists in apparatus for estimating a used part of the capacity of a battery when the battery's terminal voltage has departed from a voltage versus time curve specific to the delivery of a certain steady current by the battery, wherein the apparatus comprises: determining means for determining what the voltage is on said curve at an instant after the departure, at which instant said used part is to be estimated; first estimating means for estimating a coarse change in the used part occurring in an interval between said instant and a moment prior to, or at the time of, the departure, at which moment an earlier estimate of the used part was made; second estimating means for estimating an adjustment to said coarse change; and combining means for combining the earlier estimate, the coarse change and the adjustment to make an estimate of the used part at said instant; wherein the coarse change is estimated as the fraction of the battery's energy capacity that would be exhausted if the battery delivered a terminal voltage of said determined voltage whilst supplying said steady current for the duration of the interval; and the adjustment is calculated as the fraction of the battery's Ampere-hour rating that would be exhausted by the supply over the interval of a current that would flow through the battery's internal impedance if a potential drop substantially equal to the difference between the terminal voltage at said instant and said determined terminal voltage occurred across that impedance.

Thus, the invention is capable of producing an estimate of used part of the capacity of a battery. The earlier estimate may be rendered using the technology described as the first aspect of this invention.

Although in the majority of this document the invention is framed in terms of measuring the used part of the capacity of a battery it is to be understood that this battery could in fact be a group of batteries to be assessed. It is also to be understood that, although this document focuses on the monitoring of batteries within mobile telephones, the invention is of general applicability to monitoring the status of batteries within other kinds of device.

By way of example only, certain embodiments of the invention will now be described with reference to the accompanying drawings, in which:

Figure 1 is a schematic block diagram of a mobile telephone showing just certain elements;

Figure 2 is a plot of terminal voltage versus time for a battery feeding a constant current to a host device;

Figure 3 is a power delivered versus time curve that corresponds to the terminal voltage versus time plot of Figure 2;

Figure 4 is a terminal voltage versus energy delivered curve that corresponds to the power delivered versus time curve of Figure 3 and the terminal voltage versus time curve of Figure 2;

Figure 5 shows a family of discharge curves for different steady currents;

Figure 6 is a plot of terminal voltage versus time for a battery in the vicinity of two step changes in the current drawn from the battery;

Figure 7 is a plot of terminal voltage versus time for a period of rapid variation in the current drawn from a battery;

Figure 8 illustrates various terminal voltage versus time curves for different steady currents drawn from a battery;

Figure 9 is a plot of mean terminal voltage data for a battery, for different sampling intervals;

Figure 10 is a diagram illustrating how discharge curves are used in the estimation of the used part of battery capacity;

Figure 11 illustrates terminal voltage behaviour in the neighbourhood of a step increase in the current drawn from a battery; and

Figure 12 plots, across different sampling intervals, a trace of maximum terminal voltage values recorded in sample intervals and a trace of average terminal voltage values deduced for sampling intervals.

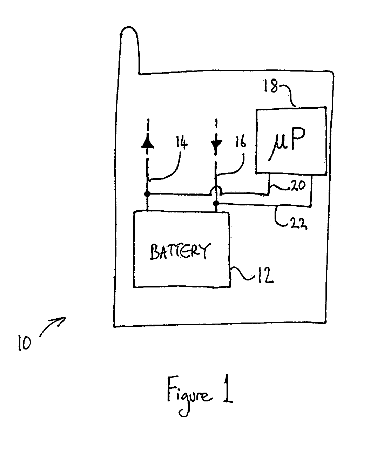

Figure 1 shows a mobile telephone 10. Only those elements most closely associated with the invention are shown and it will be apparent to the skilled person that in practice the telephone 10 will include many other elements.

The telephone 10 is powered by a battery 12, e.g. a Lithium ion battery. The battery 12 has a current supply line 14 and a current return line 16 for providing energy to the various parts of the telephone 10 through various, unillustrated, connections. Also shown is a microprocessor 18, which may be part of a larger digital processing resource within the telephone 10. Via connections 20 and 22, the microprocessor 18, can take readings of the voltage between lines 14 and 16, hereinafter referred to as the battery's "terminal voltage". The microprocessor 18, in order to provide the telephone's user with an indication of the battery's remaining capacity, uses these readings in conjunction with a model describing the behaviour of the battery 12. The model will now be described before going on to describe its application by the microprocessor 18.

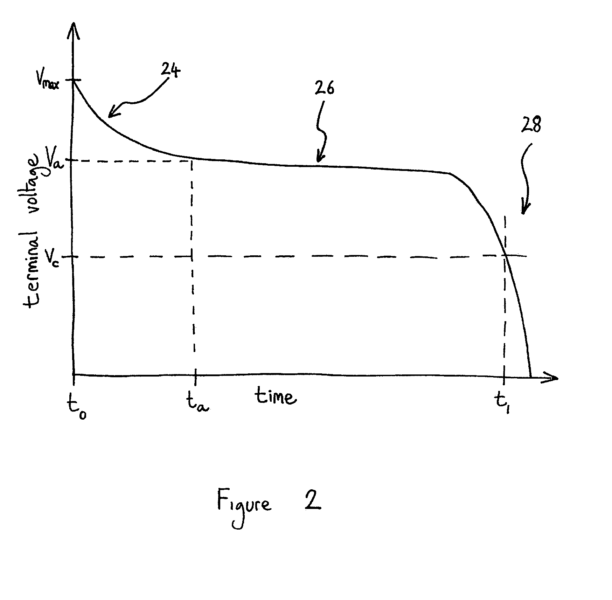

Figure 2 illustrates the typical behaviour of the terminal voltage of a battery in a battery-operated product, such as battery 12 in telephone 10, when discharged by drawing some arbitrary constant current from the battery. Initially, at time to, the battery is fully charged and the terminal voltage is at its maximum value, Vmax. As the discharging process proceeds, the terminal voltage drops quickly, indicated at 24, before settling into a gently falling plateau, indicated at 26, and then dropping steeply away, as indicated at 28, as the battery nears its completely discharged state.

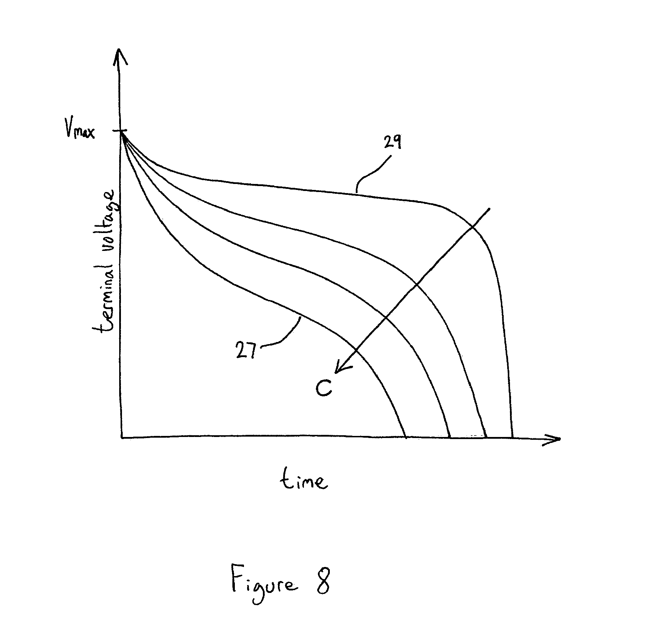

The shape of the curve in Figure 2 depends to a certain extent on the size of the steady current that is used to discharge the battery. In general terms, the higher the value of this current, the lower the plateau and the quicker the battery is discharged. Figure 8 illustrates these effects and shows terminal voltage versus time curves for different values of the steady current. Curve 27 has the highest steady current and curve 29 has the smallest steady current. The value of the steady current increases from curve to curve as one moves in the direction of the arrow marked C. In general terms, the terminal voltage at some time after commencement of the discharge process can therefore be said to vary as a function of the steady current that is drawn such that the higher the steady current, the lower the terminal voltage.

It is often the case that a battery-operated product will be provided with a cut-out function that will turn the product off if its battery's terminal voltage falls to a certain level, often known as the "cut-off voltage". The cut-out function is provided to guard against damage to, or faulty operation of, the device such as might occur if the terminal voltage fell sufficiently low.

Consider the case where the battery whose behaviour is illustrated in Figure 2 is used to power a device having a cut-off voltage of $V_c$. The voltage $V_c$ is plotted in Figure 2 so it is thus apparent that this device, if drawing from the battery the constant current to which Figure 2 relates, will cut-off at time $t_1$ after being operational for a period equal to $t_1$-$t_0$.

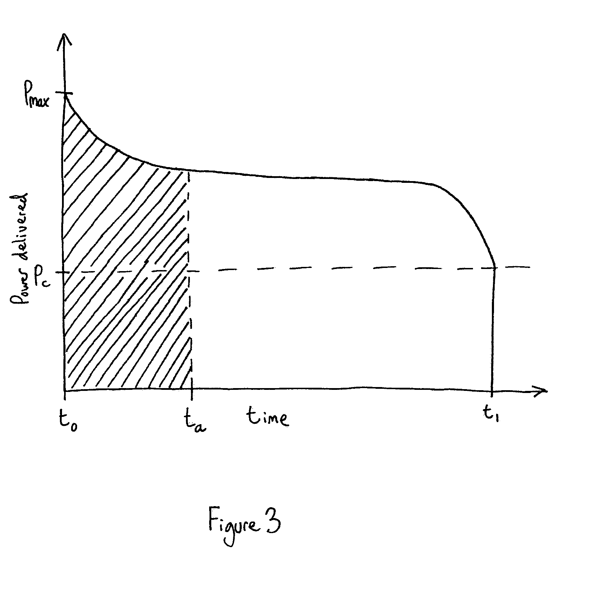

Since Figure 2 relates to a particular constant current, the terminal voltage plotted in that figure can be multiplied by that current to form a plot of power delivered by the battery versus time. Of course, multiplying the terminal voltage by a constant is equivalent to rescaling the vertical axis of Figure 2, so the power versus time curve will appear essentially the same in shape. The power delivered versus time curve that corresponds to the terminal voltage versus time plot of Figure 2 is shown in Figure 3. In Figure 3, the cut-out function operates at $P_c$ (equivalent to $V_c$), causing the delivered power to fall to zero at $t_1$.

The curve shown in Figure 3 can be integrated over time to produce a curve representing the energy, E, delivered by the battery to which Figures 2 and 3 relate (since power p=dE/dt). If this integral is evaluated between the limits $t_0$ and $t_1$ then the resulting quantity is $E_{TOT}^i$, which is total energy deliverable by the battery at the current value, i, to which Figures 2 and 3 relate. Of course, the power curve can be integrated from to up to some arbitrary time $t_a$ prior to the cut out at $t_1$ to produce a value for $E_{t_a}^i$, the energy delivered by the battery when operating at current i up until time $t_a$. The time point $t_a$ is shown in Figure 3, and $E_{t_a}^i$ is equal to the area shown shaded in Figure 3.

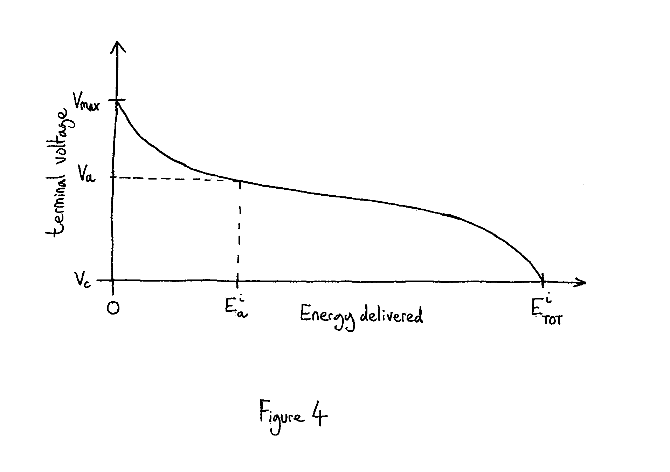

The time point $t_a$ is also marked in Figure 2, and it corresponds to a terminal voltage $V_a$. Thus, for each value of $t_a$ between $t_0$ and $t_1$, there is a corresponding $E_{t_a}^i$ value and a corresponding $V_a$ value. Accordingly,

it is possible to plot, as shown in Figure 4, terminal voltage against energy delivered for the battery operating at current i whose discharge behaviour is illustrated in Figure 2. In Figure 4, the values $V_a$ and $E_{t_a}^i$ that occur at time $t_a$ are shown and it will be noted that the terminal voltage axis ranges only from $V_c$ to Vmax (since below $V_c$, no power is delivered due to the action of the cut-out function).

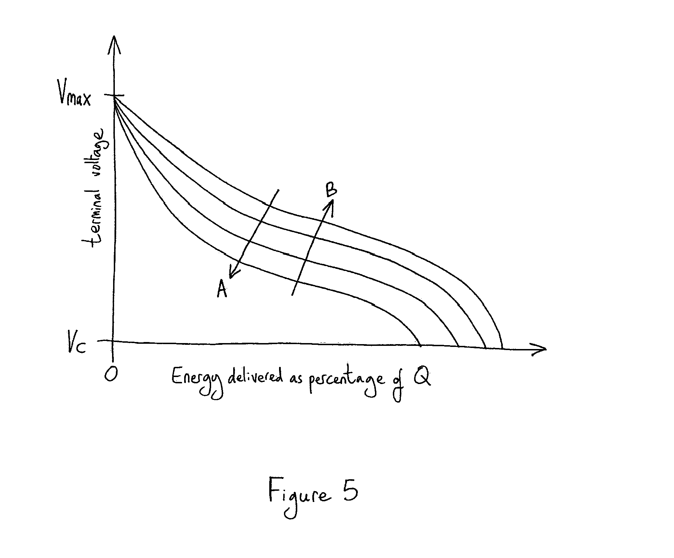

In the remainder of this document, a curve such as that shown in Figure 4 shall be referred to as a discharge curve. A discharge curve describes the relationship between terminal voltage and energy delivered, but only for a specific steady current. For a given battery used to power a given device, it is possible to deduce a family of discharge curves, each relating to a different steady current. Such a family is represented in Figure 5. Together, these curves describe a mathematical surface, which could be called a "discharge surface", in a three dimensional space whose dimensions are steady drawn current, used part of capacity and terminal voltage.

The total energy deliverable by a battery of the kind exhibiting the discharge behaviour shown in Figure 2, $E_{TOT}^i$, depends on the particular steady current, i, that is being drawn from the battery. For low values of i, $E_{TOT}^i$ is reasonably constant and is termed the battery capacity, denoted by Q. However, as i increases, $E_{TOT}^i$ then tends to decrease. Therefore, in a family of discharge curves for different values of i, the total energy deliverable, $E_{TOT}^i$, will vary. Accordingly, each discharge curve in Figure 5 is normalised in energy dimension by expressing energy delivered as a percentage of Q

Only discharge curves for four different constant currents are shown in Figure 5. It will be apparent that the family of discharge curves appears as a band. As one moves across this band in the direction marked A, the value of the steady current increases. Conversely, as one moves across this band in the direction marked B, the steady current decreases. To put it another way, the closer a discharge curve lies to the energy axis, the greater the value of steady current to which that discharge curve relates. It is also to be appreciated that energy delivered expressed as a percentage of the maximum deliverable is a measure of the part of the capacity of a battery that is used.

Returning to telephone 10, a family of discharge curves of the kind shown in Figure 5 is made available to the microprocessor 18 to enable estimates of the used part of the capacity of battery 12 to be made. The discharge curves are provided in normalised form (as in Figure 5), together with the value of Q. It might be expected that as the current drawn from the battery 12 changes, the terminal voltage simply moves to follow the terminal voltage versus time curve that corresponds to the discharge curve of the new current value. However, this is not the case, due in large part to the electrochemical time constants of the battery 12.

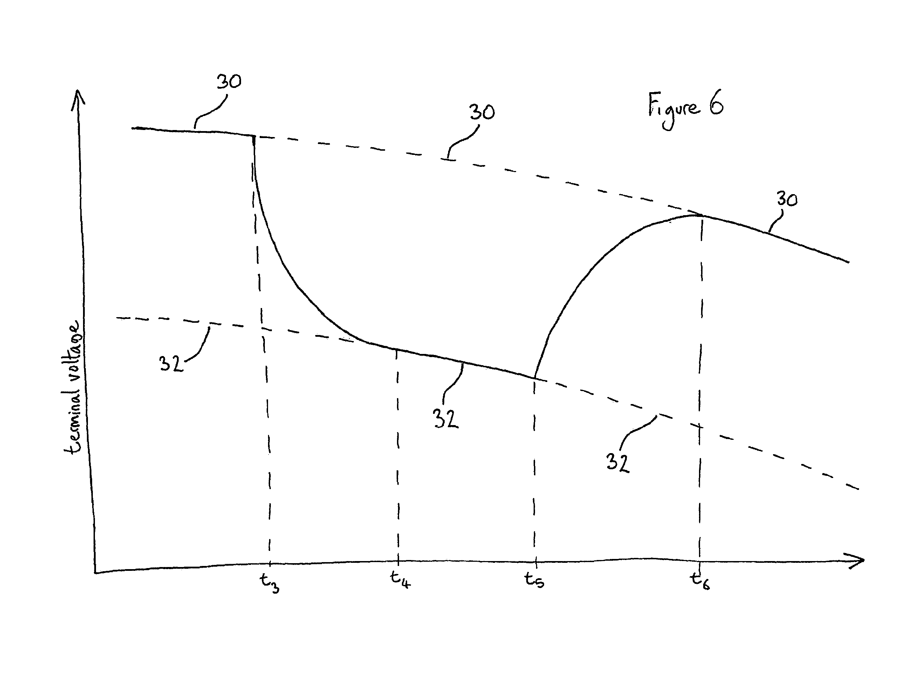

By way of a first illustration, Figure 6 shows what happens to the terminal voltage in the time domain when there is a step increase in current from $i_1$ to $i_2$ at time $t_3$ and then a step decrease at time $t_5$ to return the current to $i_1$. Prior to time $t_3$, the terminal voltage follows the terminal voltage versus time curve 30 that corresponds to the discharge curve for current $i_1$. At time $t_3$, the terminal voltage begins to follow a path leading asymptotically to the terminal voltage versus time curve 32 that corresponds to the discharge curve for current $i_2$. The terminal voltage takes until time $t_4$ to substantially arrive at the terminal voltage versus time curve 32. Then, at $t_5$, the terminal voltage sets off on an asymptotic approach to curve 30 and substantially converges with this curve only as time $t_6$ is reached.

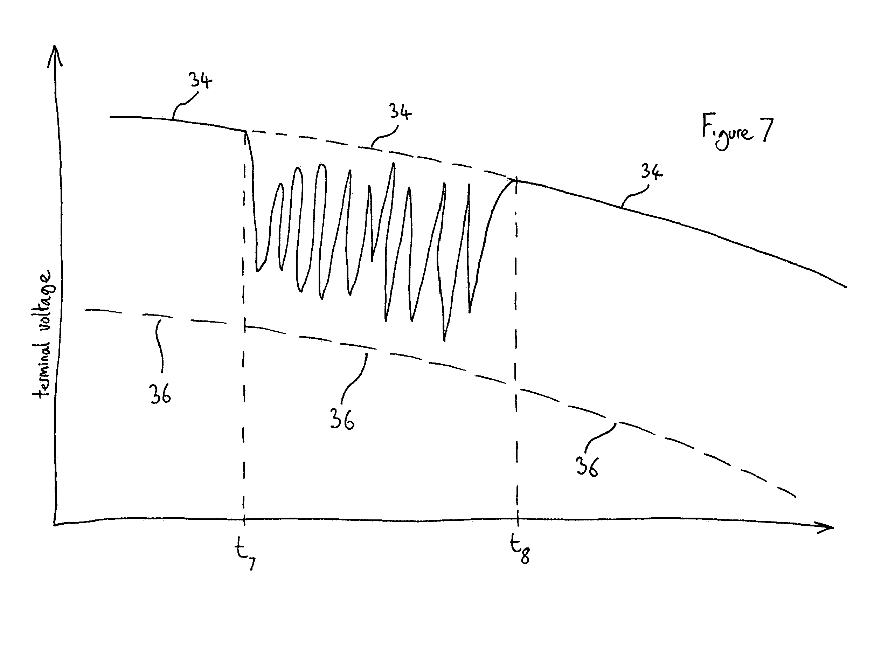

By way of a second illustration, Figure 7 shows a scenario where rapid current variation is occurring between current values $i_3$ and $i_4$ during an interval between $t_7$ and $t_8$. It will be apparent that, between $t_7$ and $t_8$, the terminal voltage fails to reach curve 34, which is the terminal voltage versus time curve corresponding to the discharge curve for current $i_3$, or to reach curve 36, which is the terminal voltage versus time curve corresponding to the discharge curve for current $i_4$.

It should therefore be apparent that when in the period between $t_3$ and $t_4$, or that between $t_5$ and $t_6$, or that between $t_7$ and $t_8$, a measurement of the terminal voltage by the microprocessor 18 will not lie on the terminal voltage versus time curve that is proper for the prevailing current thereby rendering direct capacity readings from the discharge curve family unreliable during these periods.

As a result, the microprocessor 18 is arranged to sample the terminal voltage over time, to deduce statistics from those samples and to estimate the used part of the capacity of battery 12 by applying those statistics to the provided set of discharge curves. The microprocessor 18 is arranged to perform an acquisition process at intervals on the terminal voltage in order to deduce these statistics. In each instance of the acquisition process, a group of samples of the battery's terminal voltage is gathered and the maximum, mean and minimum voltage values of the group are deduced. For the instance of the acquisition process that is initiated at time j, the maximum voltage in the group of samples shall be labelled $Vmax_j$, the mean voltage shall be labelled $Vmean_j$ and the minimum voltage shall be labelled $Vmin_j$.

The period over which an instance of the acquisition process gathers samples of the terminal voltage is chosen to be significantly longer than one frame of the network in which the telephone 10 operates but short enough so that significant depletion of the battery capacity does not occur within the period. The size of the group of samples captured in an instance of the acquisition process is chosen to be large enough to capture a representative range of system activity.

The sampling in each instance of the acquisition process is done randomly or else is done at a frequency that is intentionally chosen not to be a multiple or submultiple of the frequency of a process carried out by the telephone 10. By avoiding frequencies of processes of the telephone, the effect of aliasing on the voltage samples gathered by the acquisition process is minimised (consider, for example, the distortion of the statistics that would occur if the acquisition process were synchronised with maxima of current in a periodic transmit activity undertaken by the telephone).

The battery 12 is of the general type whose discharge behaviour was discussed with reference to Figures 2 and (in particular) 8. That is to say, at some time after the start of the discharge process, the higher the terminal voltage, then the lower the current drawn from the battery. Therefore, $Vmax_j$ can be taken to represent the minimum current that was detected in the acquisition process instance initiated at time j, $Vmin_j$ can be considered as that corresponding to that minimum current (hereinafter called the "baseline current") plus a peak excess current and $Vmean_j$ can be considered to represent the baseline current plus an average excess current.

The microprocessor 18 maintains in an associated memory (not shown) a history of the twenty most recently completed instances of the acquisition process, logging for each instance its commencement time j and the voltage statistics for that instance ($Vmax_j$, $Vmin_j$ and $Vmean_j$). The microprocessor 18 uses this "acquisition history" to estimate the battery's used capacity and has three methods at its disposal for estimating the part of the battery's capacity that has been used. Hereinafter, these methods shall be referred to as the level 1 method, the level 2 method and the level 3 method, which shall be abbreviated as the L1, L2 and L3 methods, respectively.

In general terms, the terminal voltage can, at any given time, be in the process of exhibiting one of three different behaviours. These behaviours are: responding to a steady current being drawn from the battery (as in Figure 2, for example); responding to a step change in the current being drawn from the battery (as in Figure 6, for example); and responding to a rapid variation in the current being drawn from the battery (as in Figure 7, for example). The L1 method is appropriate when the terminal voltage is exhibiting the "steady current" behaviour, the L2 method is appropriate when the terminal voltage is exhibiting the "current step" behaviour and the L3 method is appropriate when the terminal voltage is exhibiting the "rapid current variation" behaviour.

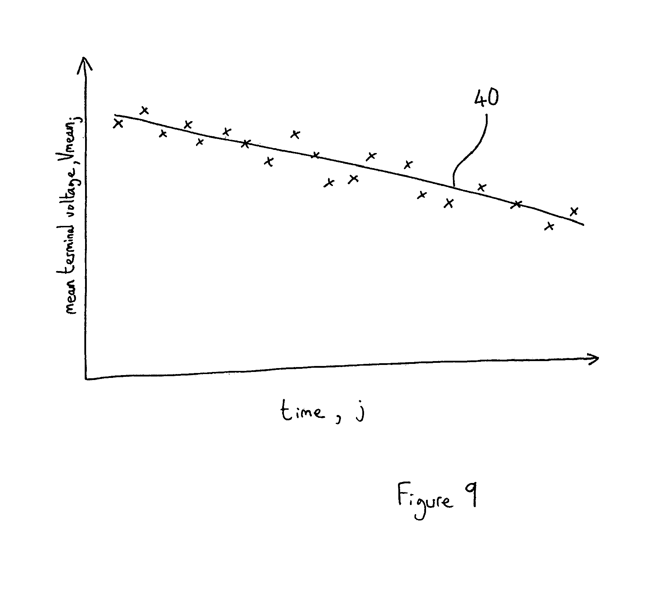

In the L1 method, the first step is to use the data in the acquisition history is used to plot a straight line. Each $Vmean_j$ and its corresponding timestamp j is considered as a point in the terminal voltage versus time plane. These points appear as crosses in the plot shown in Figure 9. A straight line 40 is fitted to these points using a minimum least squares error (MLSE) algorithm. The operation of such algorithms is well known. The line 40 has a gradient, go, that is a measure of the rate of change of the mean terminal voltage with time and the line also has a wellness of fit indicator, typically the sum of the squares of the distances, in the terminal voltage dimension, of the twenty plotted points from the line.

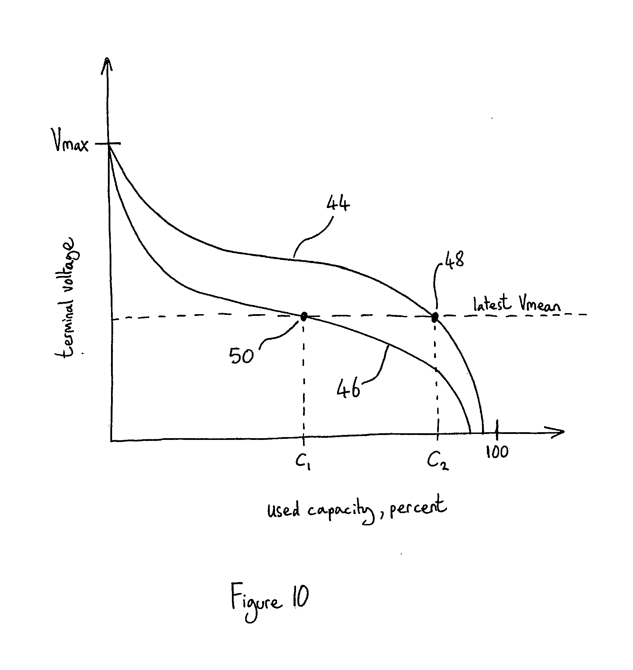

The next step in the L1 method is to locate the points on the discharge curves at which the terminal voltage value is equal to the Vmean value deduced in the latest instance of the acquisition process; each of these points corresponds to a different value of used capacity. These points shall hereinafter be referred to as the "intercept points". By way of example, Figure 10 shows two discharge curves 44 and 46, the later corresponding to the higher steady current. The latest value of Vmean appears on curves 44 and 46 at intercept points 48 and 50 respectively, which in turn respectively relate to used capacity values $C_2$ and $C_1$.

Each of the intercept points has a gradient h in the terminal voltage versus used capacity plane (dV/dC). For each of the intercept points, each lying on a respective discharge curve, it is possible to deduce a gradient in the terminal voltage versus time plane (dV/dt). Considering a normalised discharge curve corresponding to steady current i, having a gradient h at the point where the latest Vmean value, U, lies on the discharge curve, we have:

$$h = \frac{dV}{dC}$$

So:

$$h \cdot \frac{dC}{dt} = \frac{dV}{dC} \cdot \frac{dC}{dt} = \frac{dV}{dt}$$

Also, the power delivered at this point on this discharge curve is:

$$P = i.U = \frac{dE}{dt} = Q \cdot \frac{dC}{dt}$$

Then by substitution:

$$\frac{dV}{dt} = \frac{h.i.U}{Q}$$

Using this last equation, a dV/dt gradient can be deduced for each of the intercept points. The intercept point whose calculated dV/dt gradient most closely matches the gradient go (that was deduced from the acquisition history data) is therefore taken as the point specifying the current estimate of used capacity.

Returning to the example of Figure 10, assume that discharge curves 44 and 46 relate to steady currents of $i_{low}$ and $i_{high}$ respectively and that intercept points 50 and 48 have dV/dC gradients of $h_1$ and $h_2$ respectively.

Therefore, point 50 has a corresponding dV/dt gradient of:

$$g_1 = \frac{h_1.i_{high}U}{Q}$$

Similarly, point 48 has a corresponding dV/dt gradient of:

$$g_2 = \frac{h_2.i_{low}.U}{Q}$$

If $g_1$ is closer than $g_2$ to go, then $C_1$ is given as the current used capacity estimate. On the other hand, if $g_2$ is closer than $g_1$ to go, then $C_2$ is given as the used capacity estimate. If desired, interpolation between stored discharge curves can be implemented, to refine the accuracy of the used capacity estimate. Suitable interpolation techniques will be apparent to the skilled person. In practice, interpolation will home in on a point on the "discharge surface" that is between the discharge curves that describe that surface to the microprocessor 18.

Having described how a used capacity estimate is rendered using method L1, we will now describe method L2.

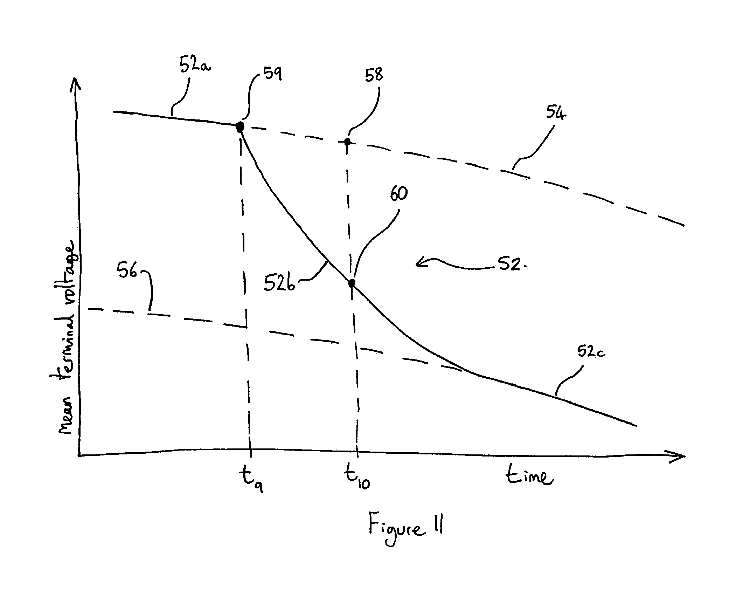

As mentioned previously, the L2 method is utilised when the terminal voltage is responding to a change from one steady current to another. In this case, the terminal voltage moves asymptotically from the terminal voltage versus time curve representing the initial current to the terminal voltage versus time curve of the new steady current. In order to make a used capacity estimate at some given time during the asymptotic change, a coarse estimate is made of the change in capacity that has occurred since the onset of the asymptotic deflection. A refinement is then made to this estimate using the excess current concept that was mentioned earlier. The L2 method shall now be described in more detail with reference to the example given in Figure 11.

Figure 11 shows the track 52 taken by successive Vmean measurements taken by the microprocessor 18. Since there is a step increase in the steady current drawn from the battery 12 at time $t_9$, the track 52 moves from following the terminal voltage versus time curve 54 corresponding to the initial current and eventually settles to follow the terminal voltage versus time curve 56 that corresponds to the step-increased current. The track 52 has three parts: a first part 52a following curve 54; a second part 52b exhibiting asymptotic movement to curve 56; and a third part 52c following curve 56. Consider now the case where a used capacity estimate is to be rendered at time $t_{10}$.

Up to time $t_9$, the current drawn from the battery 12 is steady and the L1 method can be used to make used capacity estimates. As a byproduct, the L1 method will also deduce that track part 52a corresponds to a steady current, i, being drawn from the battery (recall that the L1 method selects a particular discharge curve, which is tied to a particular steady current). Assume also that the final used capacity estimate made by applying the L1 method to track part 52a is at point 59, i.e. at $t_9$.

To produce a coarse estimate of the change in capacity from time $t_9$ to $t_{10}$, the microprocessor 18 first extrapolates curve part 52a to time $t_{10}$ and a point 58. Let the voltage at point 58 be called $U_1$. Given that curve 54 corresponds to the supply of a steady current of i, the power delivered by the battery 12 will be i.$U_1$. Earlier, it was shown that the delivered power could be rewritten as:

$$Q \cdot \frac{dC}{dt}$$

where Q is the battery capacity defined earlier. Accordingly, the rate of capacity usage at point 58 can be expressed as:

$$\frac{dC}{dt} = \frac{i.U_1}{Q}$$

Therefore, a coarse change in used capacity between times $t_9$ and $t_{10}$ will be:

$$\Delta C_o = \frac{i.U_1}{Q} . \Delta T$$

where $\Delta T = t_{10} - t_9$

This coarse estimate is then refined by taking into account the fact that, at time $t_{10}$, track part 52b lies a considerable distance below point 58 at point 60. At point 60, the mean terminal voltage is $U_2$ and the voltage difference between points 58 and 60 is $\Delta V = U_1 - U_2$. This voltage difference can be attributed to a notional excess current that is additional to the current i to which curve 54 relates. This excess current, $\Delta I$, is said to be "notional" since, in reality, the current being drawn from the battery is the step-increased value that exists after $t_9$. The microprocessor 18 is provided with a value for the internal resistance $r_{int}$ of the battery 12 which can be used to deduce the notional excess current through the equation $\Delta I = \Delta V/r_{int}$. Since the battery's capacity will be rated in Ampere-hours and this rating is known to the microprocessor 18, the fractional change in used capacity due to $\Delta I$ over period $\Delta T$ can be deduced as:

$$\Delta C_e = \frac{\Delta I.\Delta T}{R}$$

where R is the rating of the battery in Ampere-hours.

As a result, the change in used capacity that occurs during the interval $\Delta T$ is $\Delta C_t = \Delta C_o + \Delta C_e$ which can be added to the used capacity estimated under L1 at point 59 in order to yield a used capacity estimate for time $t_{10}$.

It should be noted that for any point (V, t) in segment 52b of the curve, the measured voltage lies between curves 54 and 56 whereas the slope has a greater magnitude than either of curves 54 and 56 at time t. This means that when the current is changing L2 will tend to underestimate the change whereas L1 will tend to overestimate. However, both estimates will converge as the sample points approach segment 52c

Now that the L2 method has been described, we shall move on to a description of the L3 method.

The L3 method is applied when it is desired to make a used capacity estimate during a period where the current drawn from the battery 12 is varying rapidly compared to the electrochemical time constants of the battery, much as is shown in Figure 7.

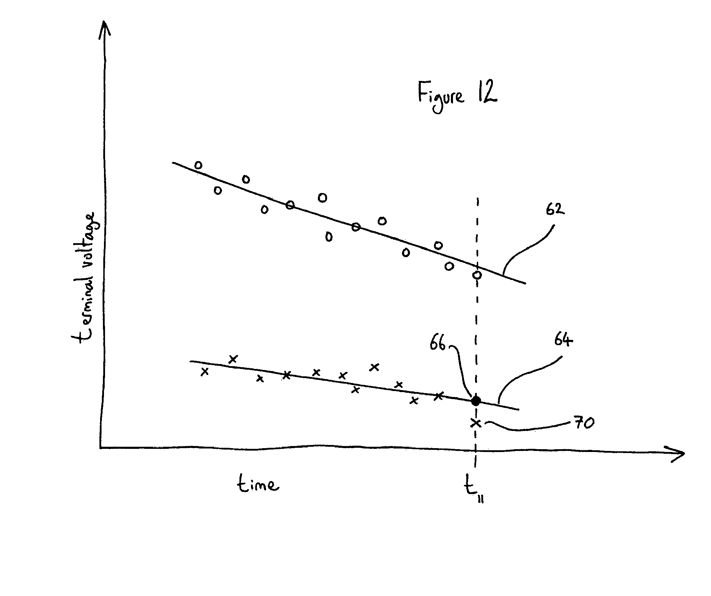

According to the L3 method, the data in the acquisition history is used to plot two straight lines 62 and 64 as shown in Figure 12. Line 64 is fitted, using a MLSE technique, to a set of points in the terminal voltage versus time plane, each point comprising a Vmean value from the acquisition history and its corresponding time stamp. These points are shown as crosses in Figure 12. Similarly, line 62 is MLSE-fitted to a set of data points in the same plane, each point this time comprising a Vmax value from the acquisition history and its corresponding timestamp. These points are shown as open circles in Figure 12.

In several respects, the L3 approach is similar to the L1 approach. In the L1 approach, the latest Vmean value is used to deduce an intercept point on each of the family of discharge curves provided to the microprocessor 18. A corresponding dV/dt gradient is deduced for each of these intercept points and the intercept point whose dV/dt gradient most closely matches the gradient of the line that is MLSE-fitted to the Vmean data points from the acquisition history is taken as the intercept point to provide the used capacity estimate.

In the L3 approach, intercept points are found on the family of discharge curves not by using the latest value of Vmean, as indicated by 70 in Figure 14, but by using the terminal voltage value of straight line 64 at time $t_{11}$, i.e. at point 66. However, the dV/dt values deduced for the intercept points (deduced, that is, using the technique described in relation to L1) are not matched to the gradient of line 64 but to the gradient of line 62 which relates to the Vmax points. The intercept point whose dV/dt value best matches this gradient is then used to supply the used capacity estimate.

The rationale behind the L3 method is that the Vmax points correspond to lower current operation, and are therefore less affected by the absolute value of the current. The slope calculation based on these values is therefore less susceptible to distortion if the current profile is changing throughout the sampling period.

## Claims

1. A method of estimating a used part of the capacity of a battery, wherein, for a given steady current supplied by the battery, a corresponding discharge curve exists describing how the battery's terminal voltage varies as said used part increases and the method comprises:

    making a record of the behaviour of the terminal voltage in a discharge cycle of the battery;
    determining a value for the terminal voltage at an instant at which said used part is to be estimated;
    deducing from said record a value, for said instant, of the gradient of terminal voltage against said used part; and
    mapping said gradient value and said terminal voltage value onto a mathematical surface linking the parameters of terminal voltage, used part of capacity and steady current supplied from the battery.

2. A method according to claim 1, wherein the determined terminal voltage value is an average of samples of the terminal voltage taken during a sampling interval.

3. A method according to claim 1 or 2, wherein said gradient value is determined from a value of rate of change of terminal voltage with time for said instant, which rate value is determined from said record.

4. A method according to claim 3, wherein said rate value is determined by taking the slope of a line fitted to average values of the terminal voltage for different sampling intervals.

5. A method according to claim 1, wherein the determined terminal voltage value is the reading of the terminal voltage value at said instant on a line fitted to average values of the terminal voltage for different sampling intervals.

6. A method according to claim 5, wherein said gradient value is determined from a value of rate of change of terminal voltage with time for said instant, which rate value is determined from said record.

7. A method according to claim 6, wherein said rate value is determined by taking the slope of a line fitted to the maximum values of the terminal voltage for different sampling intervals.

8. A method according to any one of the preceding claims, wherein a plurality of discharge curves, each describing how the battery's terminal voltage varies as said used part increases for a corresponding steady current drawn from the battery, describe said surface and the mapping step comprises identifying a point on one of the discharge curves that is the best match for said gradient value and said determined terminal voltage value.

9. A method according to any one of claims 1 to 7, wherein a plurality of discharge curves, each describing how the battery's terminal voltage varies as said used part increases for a corresponding steady current drawn from the battery, describe said surface and the mapping step comprises interpolating from the discharge curves a point on said surface that is a match for said gradient and said determined terminal voltage value.

10. A method of estimating a used part of the capacity of a battery when the battery's terminal voltage has departed from a voltage versus time curve specific to the delivery of a certain steady current by the battery, wherein the method comprises:

    determining what the voltage is on said curve at an instant after the departure, at which instant said used part is to be estimated;
    estimating a coarse change in the used part occurring in an interval between said instant and a moment prior to, or at the time of, the departure, at which moment an earlier estimate of the used part was made;
    estimating an adjustment to said coarse change; and
    combining the earlier estimate, the coarse change and the adjustment to make an estimate of the used part at said instant; wherein:

the coarse change is estimated as the fraction of the battery's energy capacity that would be exhausted if the battery delivered a terminal voltage of said determined voltage whilst supplying said steady current for the duration of the interval; and

the adjustment is calculated as the fraction of the battery's Ampere-hour rating that would be exhausted by the supply over said interval of a current that would flow through the battery's internal impedance if a potential drop substantially equal to the difference between the terminal voltage at said instant and said determined voltage occurred across that impedance.

11. A method according to claim 10, wherein the earlier estimate is rendered using the method of any one of claims 1 to 9.

12. A method according to any one of the preceding claims, wherein the battery comprises a plurality of batteries.

13. Apparatus for estimating a used part of the capacity of a battery, wherein, for a given steady current supplied by the battery, a corresponding discharge curve exists describing how the battery's terminal voltage varies as said used part increases and the apparatus comprises:

logging means for making a record of the behaviour of the terminal voltage in a discharge cycle of the battery;
processing means for determining a value for the terminal voltage at an instant at which said used part is to be estimated;
evaluating means for deducing from said record a value, for said instant, of the gradient of terminal voltage against said used part; and
assessing means for mapping said gradient value and said terminal voltage value onto a mathematical surface linking the parameters of terminal voltage, used part of capacity and steady current supplied from the battery.

14. Apparatus according to claim 13, wherein the determined terminal voltage value is an average of samples of the terminal voltage taken during a sampling interval.

15. Apparatus according to claim 13 or 14, wherein said gradient value is determined from a value of rate of change of terminal voltage with time for said instant, which rate value is determined from said record.

16. Apparatus according to claim 15, wherein said rate value is determined by taking the slope of a line fitted to average values of the terminal voltage for different sampling intervals.

17. Apparatus according to claim 13, wherein the determined terminal voltage value is the terminal voltage value at said instant on a line fitted to average values of the terminal voltage for different sampling intervals.

18. Apparatus according to claim 17, wherein said gradient value is determined from a value of rate of change of terminal voltage with time for said instant, which rate value is determined from said record.

19. Apparatus according to claim 18, wherein said rate value is determined by taking the slope of a line fitted to the maximum values of the terminal voltage for different sampling intervals.

20. Apparatus according to any one of claims 13 to 19, wherein a plurality of discharge curves, each describing how the battery's terminal voltage varies as said used part increases for a corresponding steady current drawn from the battery, describe said surface and the assessing means comprises deducing means for identifying a point on one of the discharge curves that is the best match for said gradient value and said determined terminal voltage value.

21. Apparatus according to any one of claims 13 to 19, wherein a plurality of discharge curves, each describing how the battery's terminal voltage varies as said used part increases for a corresponding steady current drawn from the battery, describe said surface and the assessing means comprises interpolating means for interpolating from the discharge curves a point on said surface that is a match for said gradient and said determined terminal voltage value.

22. Apparatus for estimating a used part of the capacity of a battery when the battery's terminal voltage has departed from a voltage versus time curve specific to the delivery of a certain steady current by the battery, wherein the apparatus comprises:

determining means for determining what the voltage is on said curve at an instant after the departure, at which instant said used part is to be estimated;
first estimating means for estimating a coarse change in the used part occurring in an interval between said instant and a moment prior to, or at the time of, the departure, at which moment an earlier estimate of the used part was made;
second estimating means for estimating an adjustment to said coarse change; and
combining means for combining the earlier estimate, the coarse change and the adjustment to make an estimate of the used part at said instant; wherein the coarse change is estimated as the fraction of the battery's energy capacity that would be exhausted if the battery delivered a terminal voltage of said determined voltage whilst supplying said steady current for the duration of the interval; and

the adjustment is calculated as the fraction of the battery's Ampere-hour rating that would be exhausted by the supply over the interval of a current that would flow through the battery's internal impedance if a potential drop substantially equal to the difference between the terminal voltage at said instant and said determined terminal voltage occurred across that impedance.

23. Apparatus according to claim 22, further comprising the apparatus of any one of claims 13 to 21 for providing said earlier estimate.

24. Apparatus according to any one of claims 13 to 23 wherein the battery comprises a plurality of batteries.

Figure 1

Figure  2

Figure 3

Figure 4

Figure 5

Figure 6

Figure 7

terminal voltage

34

34

34

36

36

36

$t_7$

$t_8$

Figure 8

Figure 9

Figure 10

Figure 11

Figure 12

Europäisches
Patentamt

European
Patent Office

Office européen
des brevets

**EUROPEAN SEARCH REPORT**

Application Number

EP 08 25 0628

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 36 24 781 A1 (VOLKSWAGEN AG [DE]) 12 February 1987 (1987-02-12) * figure 2 * ----- | 1-9, 13-21 | INV. G01R31/36 |

TECHNICAL FIELDS
SEARCHED      (IPC)

G01R

~~The present search report has been drawn up for all claims~~

| Place of search | Date of completion of the search | Examiner |
|---|---|---|
| The Hague | 6 June 2008 | Vytlacilová, Lenka |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-9, 13-21

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 08 25 0628

The Search Division considers that the present European patentapplication does not comply with the requirements of unity of invention and relates to severalinventions or groups of inventions, namely:

    1. claims: 1 - 9, 13 - 21

        a method and an apparatus for estimating SOC of a battery based on voltage gradien a method and an apparatus for estimating SOC of a battery based on voltage gradien
        ---

    2. claims: claims 10 - 12, 22 - 24

        a method and an apparatus for estimating SOC of a battery based on terminal voltage
        ---

## ANNEX TO THE EUROPEAN SEARCH REPORT
## ON EUROPEAN PATENT APPLICATION NO.

EP 08 25 0628

This annex lists the patent family members relating to the patent documents cited in  the above-mentioned European search report.
The members are as contained in the European Patent Office EDP file on
The European Patent Office is in no way liable for these particulars which are merely given for the purpose of information.

06-06-2008

| Patent document cited in search report | Publication date | Patent family member(s) | Publication date |
|---|---|---|---|
| DE 3624781    A1 | 12-02-1987 | NONE | |